# FASCICULE DE BREVET EUROPEEN

(11) **EP 1 314 211 B1**
(45) Date de publication et mention de la délivrance du brevet: **24.05.2006**
(21) Numéro de dépôt: 01967405.0
(22) Date de dépôt: 30.08.2001
(51) Int. Cl.: H01L 43/06

(54) **CAPTEUR A EFFET HALL**
HALLEFFEKT-SENSOR
HALL-EFFECT SENSOR

(30) Priorité: 30.08.2000 FR 0011087
(43) Date de publication de la demande: 28.05.2003
(73) Titulaire: CENTRE NATIONAL DE LA RECHERCHE SCIENTIFIQUE (CNRS), 75794 Paris Cedex 16 (FR)
(72) Inventeur: ROBERT, Jean-Louis, F-34920 Le Cres (FR); PERNOT, Julien 250 Route de Mende, F-34090 MONTPELLIER (FR); CAMASSEL, Jean, F-34980 Saint-Clément-de-Rivière (FR); CONTRERAS, Sylvie, F-34150 Gignac (FR)
(74) Mandataire: Breese, Pierre
(86) Numéro de dépôt international: PCT/FR2001/002703
(87) Numéro de publication internationale: WO 2002/019442

(56) Documents cités:
- EP-A- 0 458 466
- US-A- 5 354 412
- US-A- 5 536 953

## Description

La présente invention concerne le domaine des sondes de Hall, destinées à la mesure quantitative de champs magnétiques.

Le principe général des sondes à effet Hall est bien connu. On connaît en particulier des sondes constituées par une structure multicouche comprenant une couche mince d'un matériau semi-conducteur, déposée sur un substrat lui-même semi-conducteur, les deux couches étant isolées électriquement.

A titre d'exemple, le brevet européen EP572298 décrit un capteur à effet Hall « à gaz d'électrons bidimensionnel » comprenant, sur un substrat isolant, une structure à puits quantique, une couche d'apport de porteurs adjacente à la structure à puits quantique, d'épaisseur inférieure à 250 angströms et possédant une densité surfacique de donneurs intégrée sur toute l'épaisseur de la couche d'apport de porteurs inférieure à une valeur seuil, une couche d'enfouissement isolante déposée sur la couche d'apport de porteurs, possédant une bande de conduction d'énergie supérieure à l'énergie de Fermi du capteur et d'épaisseur supérieure à 200 angströms.

Le brevet européen EP458466 décrit un dispositif à effet Hall selon le préambule de la revendication 1. Plus particulièrement, ce dispositif comprend un substrat, une couche active formée en diamant semi-conducteur, déposée sur le substrat, une paire d'électrodes déposées sur des cotés opposés de la couche active, pour introduire un courant dans la couche active dans une direction, et une autre paire d'électrodes déposées sur d'autres cotés opposés de la couche active pour détecter une tension ou une composante de tension qui est induite dans une direction qui est de façon générale orthogonale à la direction du courant.

Le brevet US5536953 décrit un semi-conducteur à large bande comportant plusieurs dopants à faible concentration.

Le problème que posent les capteurs selon l'état de la technique est celui du domaine de fonctionnement. En effet, les capteurs conformes à l'état de l'art voient leurs performances métrologiques se dégrader (diminution de la sensibilité, non-linéarité.) pour des températures supérieures à 200° C.

Cette dégradation est liée au comportement de la structure (défauts d'isolation électrique couche active/substrat) et/ou de la couche active (changement des mécanismes de conduction...).

Le but de l'invention est de proposer un capteur à effet Hall présentant une faible sensibilité à la température, typiquement de moins de 250 ppm/°C pour des températures de fonctionnement supérieures à 200 °C, et présentant un coefficient de Hall KH élevé, de l'ordre de plusieurs centaines de volt/Ampère/Tesla. KH est inversement proportionnel à la densité de porteurs surfaciques et à la charge de l'électron.

À cet effet, l'invention a pour objet un capteur selon la revendication 1. Dans tous les cas, la couche active est isolée électriquement du substrat.

De préférence, la couche active est recouverte par un isolant (oxyde ou nitrure de silicium, par exemple) et par un isolant de passivation. Le taux de dopage de la couche active est choisi de façon à ce que le capteur fonctionne en régime d'exhaustion (ionisation totale des dopants) dans toute la gamme de température correspondant à l'utilisation.

Selon un premier mode de réalisation, la couche active et/ou la couche d'isolation et/ou le substrat sont constitués par une couche de carbure de silicium de type hexagonal.

Selon une variante, la couche active est une couche de carbure de silicium de type cubique. Selon une variante, la couche active est une couche de nitrures à base de GaN et/ou de ses alliages.

Selon une variante, la couche active est réalisée à partir d'un matériau à bande interdite plus faible que celle des matériaux ci-dessus (cas du silicium par exemple).

La gamme de températures correspondant au régime d'exhaustion est, dans ce cas, décalée vers les basses températures (inférieures à 200 °C) et est limitée vers les hautes températures (>200°C). La sensibilité à la température peut être plus élevée que dans les cas précédents, et non constante sur tout l'intervalle de température correspondant au régime d'exhaustion et à l'utilisation.

De préférence, les matériaux formant le substrat et la couche active sont de même nature, avec des dopages différents.

Selon une variante, la couche active pourra être transférée sur un substrat de nature différente. Elle pourra être collée par adhésion moléculaire.

Selon une variante particulière, l'invention concerne un capteur à effet Hall constitué par une structure multicouche comprenant une couche mince active, d'un matériau semi-conducteur, déposée sur un substrat semi-conducteur, les deux couches étant isolées électriquement par une couche isolante. L'ensemble de la structure est caractérisé en ce que le substrat est un matériau semi-conducteur de type n⁺, sur lequel est déposé un matériau d'isolation constitué par une couche semi-conductrice de type P⁻, et en ce que la couche mince active est de type n-.

Selon un mode de réalisation particulier, le capteur selon l'invention est constitué par un barreau présentant un tronc prolongé par deux paires de bras latéraux, le tronc présentant à chacune de ses extrémités une électrode pour l'alimentation électrique, deux bras latéraux opposés comportant des électrodes pour l'acquisition du signal de Hall, et deux bras adjacents présentant des électrodes pour la mesure de la résistance.

La présente invention sera mieux comprise à la lecture de la description d'un exemple non limitatif de réalisation qui suit, ce référant aux dessins annexés où :
- la figure 1 représente une vue de dessus d'un capteur selon l'invention ;
- la figure 2 représente une vue selon un plan de coupe médian dudit capteur.

Le capteur de Hall selon l'exemple de réalisation décrit à titre d'exemple présente une forme générale de « croix de Lorraine » avec un corps (1), une première paire de bras (2, 3) latéraux et une seconde paire de bras latéraux (4, 5), l'ensemble étant destiné à une mesure d'un champ magnétique perpendiculaire au plan formé par l'axe médian du corps (1) et par l'axe médian d'une paire de bras au moins (2, 3 par exemple).

L'une des paires de bras (2, 3) présente des électrodes (6, 7) pour l'acquisition du signal de Hall.

Le corps présente par ailleurs deux électrodes (8, 9) disposées à ses extrémités opposées, pour l'alimentation avec une tension d'excitation ou une alimentation en courant. En outre, deux bras adjacents (2, 4) présentant des électrodes (6,10) pour la mesure de la résistance de la structure, mesure qui permet de déduire la température du capteur de Hall.

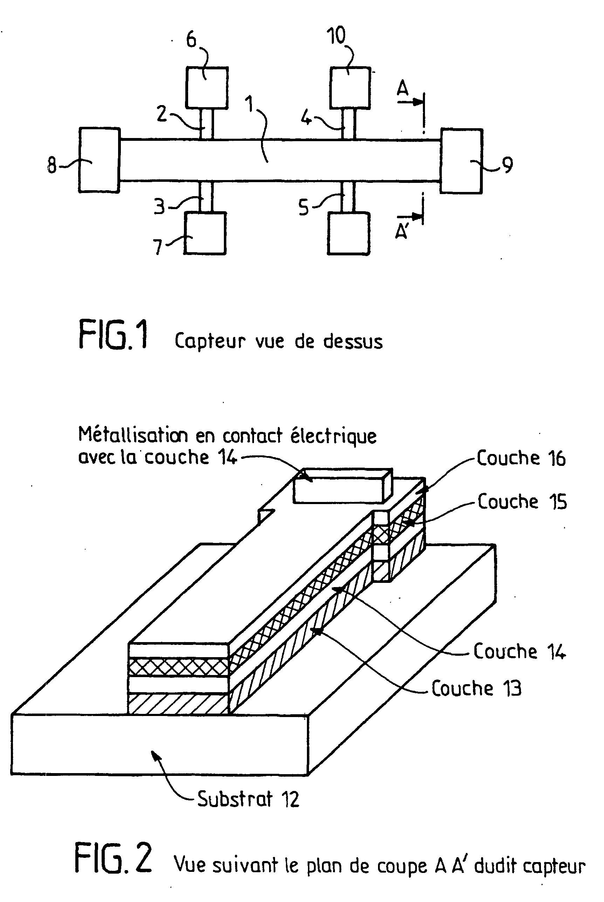

La figure 2 représente une vue selon un plan de coupe transversal. La sonde de Hall selon un premier mode de réalisation de l'invention est conçue pour présenter une impédance de quelques kilo-ohms, typiquement de l'ordre de 10 kilo-ohms, une sensibilité thermique de l'ordre de 200 ppm/°C et un facteur KH de l'ordre de plusieurs centaines de V/A/T.

Pour atteindre ces performances, la sonde de Hall selon l'invention est constituée par un substrat (12) réalisé en un semi-conducteur dopé n⁺. Le semi-conducteur est monocristallin de type carbure de silicium (SiC) de préférence de type 4H - SiC.

Sur ce substrat est déposée, par exemple par épitaxie, une couche d'isolation (13). Cette couche est constituée d'un matériau semi-conducteur identique à celui du substrat dopé p⁻.

Sur cette couche d'isolation (13) est déposée une couche mince active (14) constituée d'un semi-conducteur dopé n⁻. Le semi-conducteur est monocristallin de type carbure de silicium SiC, de type 4H-SiC.

La couche active est elle-même revêtue de façon optionnelle par une couche d'isolant (15) et une couche de passivation (16), par exemple en oxyde de Silicium (SiO₂).

La structure du capteur selon l'invention met en oeuvre des semi-conducteurs à grand gap, travaillant en régime d'exhaustion.

Selon une variante, la couche active pourra être déposée sous forme de nitrures (GaN et/ou alliages). Le substrat pourra être soit du saphir sur lequel sera déposée une couche tampon, soit du carbure de silicium avec couche tampon, soit un nitrure ou tout autre substrat.

## Revendications

1. Capteur à effet Hall constitué par une structure multicouche comprenant une couche mince active déposée sur un substrat (10), **caractérisé en ce que** le substrat (10) est en carbure de silicium monocristallin et **en ce que** la couche active (14) est constituée d'un matériau semi-conducteur de type n- ou p- dopé à un taux inférieur à 5.10¹⁵ cm-3 en régime d'exhaustion.

2. Capteur à effet Hall selon la revendication 1, **caractérisé en ce que** la couche active (14) de type n-est déposée sur une couche d'isolement électrique (13) de type P⁻ pour isoler électriquement la couche active (14) du substrat (12).

3. Capteur à effet Hall selon la revendication 1 ou 2, **caractérisé en ce que** la couche active (14) de type n- est recouverte par un oxyde thermique (15) et par un isolant de passivation (16).

4. Capteur à effet Hall selon l'une quelconque des revendications précédentes, **caractérisé en ce que** la couche active (14) est une couche de carbure de silicium de type hexagonal.

5. Capteur à effet Hall selon l'une quelconque des revendications précédentes, **caractérisé en ce que** la couche d'isolation est une couche de carbure de silicium de type hexagonal de type p-.

6. Capteur à effet Hall selon l'une quelconque des revendications précédentes, **caractérisé en ce que** le substrat (12) est une couche de carbure de silicium de type hexagonal.

7. Capteur à effet Hall selon l'une quelconque des revendications précédentes, **caractérisé en ce que** la couche active (14) est une couche de carbure de silicium cubique.

8. Capteur à effet Hall selon l'une quelconque des revendications précédentes, **caractérisé en ce que** la couche active (14) est une couche de nitrures à base de GaN et/ou de ses alliages.

9. Capteur à effet Hall selon l'une quelconque des revendications précédentes, **caractérisé en ce que** la couche active (14) est une couche de silicium.

10. Capteur à effet Hall selon l'une quelconque des revendications précédentes, **caractérisé en ce que** les matériaux semi-conducteur formant le substrat (12), la couche d'isolation (13) et la couche active (14) sont de même nature.

11. Capteur à effet Hall selon l'une quelconque des revendications 1 à 8, **caractérisé en ce que** la couche active (14) est rapportée sur un support [couche d'isolation ou couche tampon et substrat] et **en ce que** le substrat (12) et la couche active sont de nature différente.

12. Capteur à effet Hall selon l'une quelconque des revendications précédentes, **caractérisé en ce qu'**il est constitué par un barreau présentant un tronc prolongé par deux paires de bras latéraux, le tronc présentant à chacun de ses extrémités une électrode pour l'alimentation électrique, deux bras latéraux opposés comportant des électrodes pour l'acquisition du signal de Hall, et deux bras adjacents présentant des électrodes pour la mesure de la résistance.

## Claims

1. Hall-effect sensor composed of a multi-layer structure comprising an active thin layer deposited on a substrate (10), **characterised in that** the substrate (10) is made of monocrystalline silicon carbide and **in that** the active layer (14) is composed of an n- or p- type semiconducting material doped with a content less than 5 x 10¹⁵ cm⁻³ under exhaustion conditions.

2. Hall-effect sensor according to claim 1, **characterised in that** the n- type active layer (14) is deposited on a p- type electrical insulation layer (13) to electrically isolate the active layer (14) from the substrate (12).

3. Hall-effect sensor according to claim 1 or 2, **characterised in that** the n- type active layer (14) is covered by a thermal oxide (15) and by a passivation insulation (16).

4. Hall-effect sensor according to any one of the above claims, **characterised in that** the active layer (14) is a hexagonal type silicon carbide layer.

5. Hall-effect sensor according to any one of the above claims, **characterised in that** the insulation layer is a hexagonal p- type silicon carbide layer.

6. Hall-effect sensor according to any one of the above claims, **characterised in that** the substrate (12) is a hexagonal type silicon carbide layer.

7. Hall effect sensor according to any one of the above claims, **characterised in that** the active layer (14) is a cubic type silicon carbide layer.

8. Hall-effect sensor according to any one of the above claims, **characterised in that** the active layer (14) is a layer of nitrides based on GaN and / or its alloys.

9. Hall-effect sensor according to any one of the above claims, **characterised in that** the active layer (14) is a silicon layer.

10. Hall-effect sensor according to any one of the above claims, **characterised in that** the semiconducting materials forming the substrate (12), the insulation layer (13) and the active layer (14) are of the same nature.

11. Hall-effect sensor according to any one of claims 1 to 8, **characterised in that** the active layer (14) is added onto a support (insulation layer or buffer layer and substrate) and **in that** the substrate (12) and the active layer are of different natures.

12. Hall-effect sensor according to any one of the previous claims, **characterised in that** it is composed of a bar with a trunk prolonged by two pairs of lateral arms, the trunk having an electrode for the electrical power supply at each of its ends, two opposite lateral arms with electrodes for acquisition of the Hall signal, and two adjacent arms with electrodes to measure the resistance.

## Patentansprüche

1. Halleffekt-Sensor bestehend aus einer Mehrschicht-Struktur, die eine dünne, aktive Schicht umfasst, die auf ein Substrat (10) aufgebracht wurde, **dadurch gekennzeichnet, dass** das Substrat (10) aus monokristallinem Siliziumkarbid besteht und dass die aktive Schicht (14) aus einem Halbleitermaterial, Typ n oder p, besteht, dotiert mit einem Faktor unter 5 x 10¹⁵ cm⁻³ ersatzlos.

2. Halleffekt-Sensor gemäß Anspruch 1, **dadurch gekennzeichnet, dass** die aktive Schicht (14), Typ n⁻, auf einer elektrischen Isolierschicht (13), Typ p⁻, zur elektrischen Isolierung der aktiven Schicht (14) des Substrates (12) aufgebracht ist.

3. Halleffekt-Sensor gemäß Anspruch 1 oder 2, **dadurch gekennzeichnet, dass** auf die aktive Schicht (14), Typ n⁻, ein thermisches Oxid (15) und ein Passivierungsisolationsstoff (16) aufgebracht ist.

4. Halleffekt-Sensor gemäß einem der vorherigen Ansprüche, **dadurch gekennzeichnet, dass** die aktive Schicht (14) eine Schicht aus hexagonalem Siliziumkarbid ist.

5. Halleffekt-Sensor gemäß einem der vorherigen Ansprüche, **dadurch gekennzeichnet, dass** die Isolierschicht eine Schicht aus hexagonalem Siliziumkarbid, Typ p-, ist.

6. Halleffekt-Sensor gemäß einem der vorherigen Ansprüche, **dadurch gekennzeichnet, dass** das Substrat (12) eine Schicht aus hexagonalem Siliziumkarbid ist.

7. Halleffekt-Sensor gemäß einem der vorherigen Ansprüche, **dadurch gekennzeichnet, dass** die aktive Schicht (14) eine Schicht aus kubischem Siliziumkarbid ist.

8. Halleffekt-Sensor gemäß einem der vorherigen Ansprüche, **dadurch gekennzeichnet, dass** die aktive Schicht (14) eine Schicht aus Nitriden ist, auf Basis von GaN und/oder seiner Legierungen.

9. Halleffekt-Sensor gemäß einem der vorherigen Ansprüche, **dadurch gekennzeichnet, dass** die aktive Schicht (14) eine Siliziumschicht ist.

10. Halleffekt-Sensor gemäß einem der vorherigen Ansprüche, **dadurch gekennzeichnet, dass** die Halbleitermaterialien, die das Substrat (12), die Isolierschicht (13) und die aktive Schicht (14) bilden, gleicher Natur sind.

11. Halleffekt-Sensor gemäß einem der Ansprüche 1 bis 8, **dadurch gekennzeichnet, dass** die aktive Schicht (14) auf einen Träger (Isolierschicht oder Pufferschicht und Substrat) übertragen wird und **dadurch**, dass das Substrat (12) und die aktive Schicht unterschiedlicher Natur sind.

12. Halleffekt-Sensor gemäß einem der vorherigen Ansprüche, **dadurch gekennzeichnet, dass** er aus einem Stab mit einem Schaft besteht, der durch zwei seitliche Armpaare verlängert ist, wobei der Schaft an jeder Seite eine Elektrode zur Stromversorgung, aufweist, zwei seitliche, entgegengesetzte Arme, die Elektroden zur Erfassung des Hallsignals aufweisen und zwei nebeneinanderliegende Arme mit Elektroden zur Widerstandsmessung.
